# EUROPEAN PATENT SPECIFICATION

(11) **EP 4 565 047 B1**
(45) Date of publication and mention of the grant of the patent: **13.05.2026**
(21) Application number: 24209076.9
(22) Date of filing: 25.10.2024
(51) Int. Cl.: H10K 59/80

(54) **DISPLAY DEVICE**
ANZEIGEVORRICHTUNG
DISPOSITIF D'AFFICHAGE

(30) Priority: 30.11.2023 KR 20230171221
(43) Date of publication of application: 04.06.2025
(73) Proprietor: Samsung Display Co., Ltd., Gyeonggi-do 17113 (KR)
(72) Inventor: LEE, Eun Bee, 17113 Yongin-si (KR); KIM, Su Jeong, 17113 Yongin-si (KR); KIM, Woo Young, 17113 Yongin-si (KR); LEE, Kwan Hee, 17113 Yongin-si (KR); LEE, Jung Woo, 17113 Yongin-si (KR); LEE, Jin Hyeong, 17113 Yongin-si (KR)
(74) Representative: Taor, Simon Edward William

(56) References cited:
- EP-A1- 4 099 389
- KR-A- 20230 068 496

## Description

This application claims priority to and benefits of Korean Patent Application No. 10-2023-0171221, filed on November 30, 2023.

### BACKGROUND

### 1. Technical Field

The disclosure relates to a display device.

### 2. Description of the Related Art

Importance of a display device is increasing with development of multimedia. In response to this, various types of display devices, such as an organic light emitting diode (OLED) display device and a liquid crystal display (LCD), are used.

A display device is a device that displays an image and includes a display panel such as an organic light emitting display panel or a liquid crystal display panel. Among them, the organic light emitting display panel (OLED panel) is attracting attention as a display device because of its advantages such as low-voltage driving, light weight and thinness, a wide viewing angle, and a fast response speed. In particular, when using a color filter in such a display device, securing a reflection characteristic by reducing a reflectance and improving efficiency is required.

EP4099389A1 discloses a display device including a base substrate; a thin-film transistor disposed on the base substrate; a via layer disposed on the thin-film transistor and having a via hole formed therein, the via hole penetrating the via layer in a thickness direction; a first electrode disposed on the via layer and having an electrode hole formed therein, the electrode hole penetrating the first electrode in the thickness direction; a bank layer disposed on the first electrode and exposing part of a top surface of the first electrode; an emission layer on the first electrode; and a second electrode on the emission layer, wherein the first is electrically connected to the thin-film transistor through the via hole, and the bank layer includes an outer bank pattern, which overlaps with the via hole in the thickness direction, and a bank island pattern, which is disposed in the electrode hole.

KR20230068496A discloses a display device with a light emitting device having a first light blocking member overlapping the center of the emission area and second light blocking member overlapping non-emission area between the pixel electrodes.

The content described above is only intended to help understanding of the background technology of the technical ideas of the disclosure, and thus it cannot be understood as a content corresponding to prior art known to those skilled in the art of the disclosure.

### SUMMARY

Embodiments of the disclosure are for providing a display device with improved efficiency.

The technical objectives to be achieved by the disclosure are not limited to those described herein, and other technical objectives that are not mentioned herein would be clearly understood by a person skilled in the art from the description of the disclosure.

According to an aspect, there is provided a display device as set out in claim 1. Additional features are set out in the dependent claims.

### BRIEF DESCRIPTION OF THE DRAWINGS

The above and other features of the disclosure will become more apparent by describing in further detail embodiments thereof with reference to the accompanying drawings, in which:
FIG. 1 is a schematic block diagram illustrating a display device according to embodiments of the disclosure;
FIG. 2 is a schematic plan view of a display panel of FIG. 1;
FIG. 3 is a schematic cross-sectional view of the display panel of FIG. 1;
FIG. 4 is a schematic diagram of an equivalent circuit illustrating an embodiment of a pixel included in the display device of FIG. 1;
FIG. 5 is a schematic plan view illustrating an embodiment of a pixel unit of FIG. 2;
FIG. 6 is a schematic cross-sectional view taken along line I-I' of FIG. 5 according to an embodiment of the display panel;
FIG. 7 is a schematic cross-sectional view taken along line I-I' of FIG. 5 according to an embodiment of the display panel;
FIGS. 8 to 10 are schematic enlarged views of a portion A of FIG. 7 according to various embodiments of the display panel; and
FIGS. 11 and 12 are schematic plan views illustrating other embodiments of the pixel unit of FIG. 2.

### DETAILED DESCRIPTION OF THE EMBODIMENT

Hereinafter, one or more embodiments according to the disclosure are described in detail with reference to the accompanying drawings. It should be noted that in the following description, only portions necessary for understanding an operation according to the disclosure are described, and descriptions of other portions are omitted in order not to obscure the subject matter of the disclosure. In addition, the disclosure may be embodied in other forms without being limited to the embodiments described herein. However, the embodiments described herein are provided to describe in detail enough to readily implement the disclosure to those skilled in the art to which the disclosure belongs.

Throughout the specification, in a case where a portion is "connected" to another portion, the case includes not only a case where the portion is "directly connected" but also a case where the portion is "indirectly connected" with another element interposed therebetween. Terms used herein are for describing specific embodiments and are not intended to limit the disclosure. Throughout the specification, in a case where a certain portion "includes", the case means that the portion may further include another component without excluding another component unless otherwise stated.

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

The term "and/or" includes all combinations of one or more of which associated configurations may define. For example, "A and/or B" may be understood to mean "A, B, or A and B."

Here, terms such as first and second may be used to describe various components, but these components are not limited to these terms. These terms are used to distinguish one component from another component. Therefore, a first component may refer to a second component within a range without departing from the scope disclosed herein.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

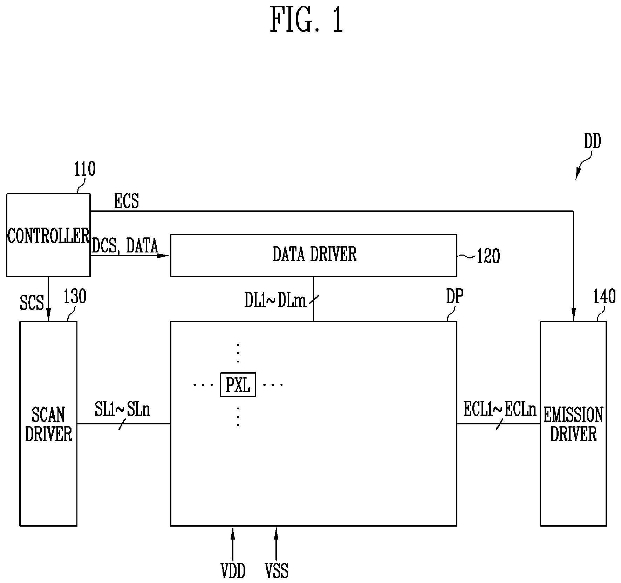

FIG. 1 is a schematic block diagram illustrating a display device according to embodiments of the disclosure.

Referring to FIG. 1, a display device DD may include a display panel DP, a controller 110, a data driver 120, a scan driver 130, and/or an emission driver 140.

The display panel DP may include one or more pixels PXL. The display panel DP may be connected to scan lines SL1 to SLn, data lines DL1 to DLm, and emission lines ECL1 to ECLn. The scan lines SL1 to SLn, the data lines DL1 to DLm, and the emission lines ECL1 to ECLn may be disposed on the display panel DP to cross or intersect each other. The pixels PXL may be electrically connected to the scan lines SL1 to SLn, the data lines DL1 to DLm, and/or the emission lines ECL1 to ECLn in the display panel DP.

The display panel DP may be of various types of panels, such as an organic light emitting diode (OLED) panel. A type of lines disposed in the display panel DP may vary according to a pixel structure, a panel type, and the like.

The controller 110 may control an operation of the data driver 120, the scan driver 130, and/or the emission driver 140. The controller 110 may provide a first control signal SCS to the scan driver 130 to apply a scan signal to the scan lines SL1 to SLn according to a timing implemented in each frame. The controller 110 may provide an image data signal DATA converted from a data format of an image signal to suit an interface specification of the data driver 120. In case that the scan signal is applied to the scan lines SL1 to SLn, the controller 110 may provide a second control signal DCS to the data driver 120 to apply data voltages to the data lines DL1 to DLm. The controller 110 may provide a third control signal ECS to the emission driver 140 to apply an emission control signal to the emission control lines ECL1 to ECLn.

The controller 110 may be a timing controller used in typical display technology, or may be a control device that may perform another control function by including the timing controller.

The data driver 120 may output data signals to the data lines DL1 to DLm. For example, the data driver 120 may receive the second control signal DCS and the image data signal DATA from the controller 110. The data driver 120 may convert the image data signal DATA into the data signals and output the data signals to the data lines DL1 to DLm. The data signals may be analog voltages corresponding to grayscale values of the image data signal DATA. For example, in case that a specific scan line is selected by the scan driver 130, the data driver 120 may supply analog data voltages to the data lines DL1 to DLm.

The scan driver 130 may receive the first control signal SCS from the controller 110. The scan driver 130 may output a scan signal to the scan lines SL1 to SLn. The scan driver 130 may sequentially supply the scan signals to the scan lines SL1 to SLn according to the first control signal SCS from the controller 110. The pixels PXL receiving each scan signal may receive analog voltages of grayscale values corresponding to the image data signal DATA and output light of a luminance corresponding to the received analog voltages in response to the emission control signal. Accordingly, an image may be displayed on the display panel DP.

The emission driver 140 may receive the third control signal ECS from the controller 110. The emission driver 140 may supply the emission control signal to the emission control lines ECL1 to ECLn in response to the third control signal ECS. The third control signal ECS may include a start signal and clock signals for the emission control signal. The emission control signal may be set to a gate-off level (for example, a high voltage). A transistor receiving the emission control signal may be turned off in case that the emission control signal is supplied, and may be set to turn on in other cases.

In FIG. 1, for convenience of description, the data driver 120, the scan driver 130, and the emission driver 140 are shown as separate components, respectively, but embodiments of the disclosure are not limited thereto. For example, at least some of the data driver 120, the scan driver 130, and the emission driver 140 may be integrated into one driving circuit, module, or the like.

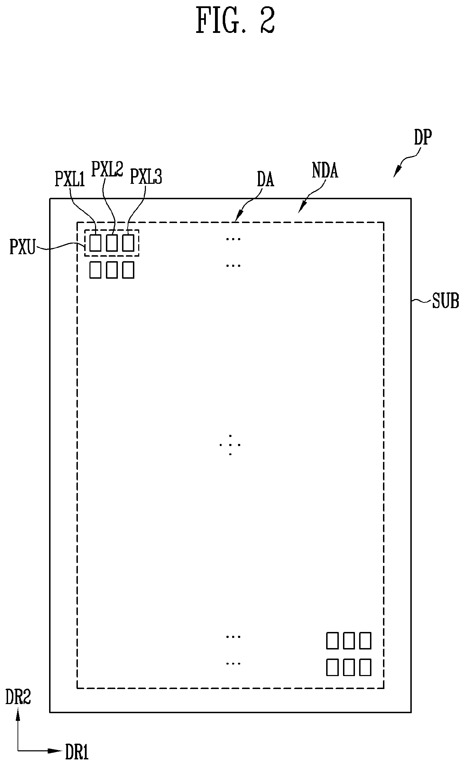

FIG. 2 is a schematic plan view of the display panel of FIG. 1.

Referring to FIG. 2, the display panel DP and a substrate SUB for forming the same may include a display area DA for displaying an image and a non-display area NDA except for the display area DA. The display area DA may configure a screen on which an image is displayed, and the non-display area NDA may be a remaining area except for the display area DA.

For convenience of description, a structure of the display panel DP is briefly shown in FIG. 2 based on the display area DA. However, although not shown in FIG. 2, at least one driving circuit (for example, at least one of the scan driver, the data driver, and the emission driver), lines, and/or pads may be further disposed on the display panel DP.

Pixel units may be disposed in the display area DA. Each pixel unit may include a first pixel PXL1, a second pixel PXL2, and/or a third pixel PXL3. In FIG. 2, the first pixel PXL1, the second pixel PXL2, and the third pixel PXL3 included in a pixel unit PXU are illustrated for clear and concise description. Other pixel units may also be understood to include the first pixel PXL1, the second pixel PXL2, and the third pixel PXL3.

Hereinafter, in case that at least one pixel among the first pixel PXL1, the second pixel PXL2, and the third pixel PXL3 is arbitrarily referred to, or in case that two or more types of pixels are collectively referred to, the at least one pixel or the two or more types of pixels are referred to as a "pixel PXL" or "pixels PXL".

The pixels PXL may be arranged (or regularly arranged) according to a stripe or PENTILE^{™} arrangement structure, or the like. However, an arrangement structure of the pixels PXL is not limited thereto, and the pixels PXL may be arranged in the display area DA in various structures and/or methods.

According to an embodiment, two or more types of pixels PXL emitting light of different colors may be disposed in the display area DA. For example, in the display area DA, the first pixel PXL1 emitting light of a first color, the second pixel PXL2 emitting light of a second color, and the third pixel PXL3 emitting light of a third color may be arranged. At least one of the first to third pixels PXL1, PXL2, and PXL3 disposed to be adjacent to each other may configure a pixel unit PXU capable of emitting light of various colors. For example, the first pixel PXL1 may be a red pixel emitting red light, the second pixel PXL2 may be a green pixel emitting green light, and the third pixel PXL3 may be a blue pixel emitting blue light, but embodiments of the disclosure are not limited thereto.

However, in FIG. 2, a case where the pixel unit PXU includes one first pixel PXL1, one second pixel PXL2, and one third pixel PXL3 is shown, but embodiments of the disclosure are not limited thereto. For example, the pixel unit PXU may include one first pixel PXL1, two second pixels PXL2, and one third pixel PXL3.

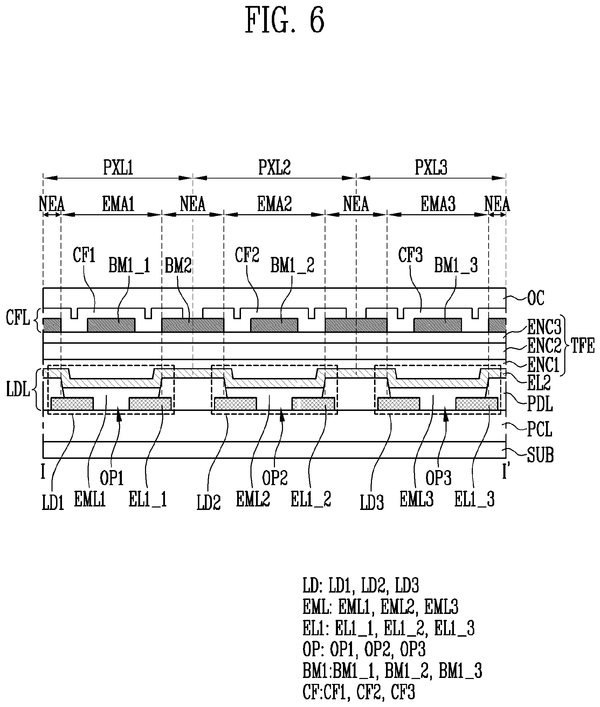

The first pixel PXL1, the second pixel PXL2, and the third pixel PXL3 may respectively include a first light emitting element LD1 (see FIG. 6), a second light emitting element LD2 (see FIG. 6), and a third light emitting element LD3 (see FIG. 6) as a light source. Accordingly, the first pixel PXL1, the second pixel PXL2, and the third pixel PXL3 may emit the light of the first color, the light of the second color, and the light of the third color, respectively. However, a color of the light emitted from each of the pixels PXL may variously change.

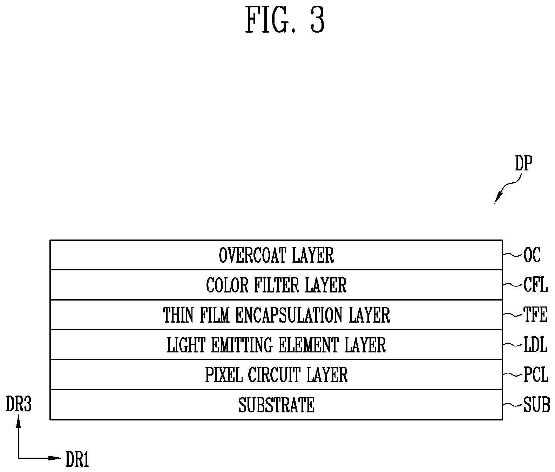

FIG. 3 is a schematic cross-sectional view of the display panel of FIG. 1.

Referring to FIG. 3, the display panel DP may include the substrate SUB, a pixel circuit layer PCL, a light emitting element layer LDL, a thin-film encapsulation layer TFE, a color filter layer CFL, and an overcoat layer OC.

The substrate SUB may include a semiconductor substrate. As an example, the substrate SUB may include a silicon bulk wafer or an epitaxial wafer. The epitaxial wafer may include a crystalline material layer, for example, an epitaxial layer, grown by an epitaxial process on a bulk substrate. The substrate SUB is not limited to the bulk wafer or the epitaxial wafer, and may be formed using various wafers such as a polished wafer, an annealed wafer, and silicon-on-insulator (SOI) wafer.

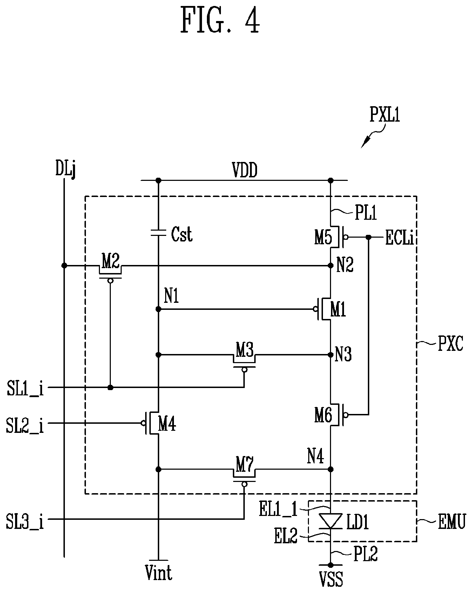

The pixel circuit layer PCL may be disposed on the substrate SUB and may include circuit elements of a pixel circuit PXC (see FIG. 4) and at least one insulating layer positioned between the circuit elements. The circuit elements may include one or more transistors and signal lines connected to the transistors. For example, the transistors may be metal-oxide-semiconductor field-effect transistors (MOSFETs), but embodiments are not limited thereto. The circuit elements may include a gate electrode, source/drain areas, and a channel area.

The above-described substrate SUB and pixel circuit layer PCL may be formed by applying a semiconductor process and equipment, but embodiments of the disclosure are not limited thereto.

The light emitting element layer LDL may include light emitting elements LD (see FIG. 6) and a pixel defining layer PDL (see FIG. 6). The light emitting elements LD may be positioned in the first to third pixels PXL1 to PXL3. The light emitting elements LD may include first electrodes (or pixel electrodes) EL1 (see FIG. 6), light emitting layers EML (see FIG. 6), and a second electrode (or common electrodes) EL2 (see FIG. 6). The first electrodes EL1 may be anodes of the light emitting elements LD, and the second electrode EL2 may be cathodes of the light emitting elements LD.

The thin-film encapsulation layer TFE may be positioned on the light emitting element layer LDL. The thin-film encapsulation layer TFE may cover (or overlap) the light emitting element layer LDL to prevent oxygen, moisture, and/or the like from permeating into the light emitting element layer LDL.

The color filter layer CFL may be positioned on the thin-film encapsulation layer TFE. The color filter layer CFL may selectively transmit light emitted from the light emitting elements LD in an image display direction or (a front direction) of the display device DD, but embodiments of the disclosure are not limited thereto.

The overcoat layer OC may be disposed on the pixels PXL having the above-described configuration. The overcoat layer OC may cover lower members including the color filter layer CFL. The overcoat layer OC may protect the above-described lower members from a foreign substance such as dust. However, an embodiment in which the overcoat layer OC is not included in each of the pixels PXL and is a separate component is described as an example, but embodiments is not limited thereto. The overcoat layer OC may be a partial component included in each of the pixels PXL.

FIG. 4 is a schematic diagram of an equivalent circuit illustrating an embodiment of a pixel included in the display device of FIG. 1. In FIG. 4, for convenience of description, a first pixel PXL1 included in any one of pixel units positioned in an i-th pixel row in the display panel DP of FIG. 1 is shown.

Referring to FIGS. 2 and 4, the first pixel PXL1 may be positioned in the i-th pixel row and a j-th pixel column (where i and j are natural numbers). Each of the first to third pixels PXL1 to PXL3 may be configured substantially similarly. Hereinafter, the disclosure is described based on the first pixel PXL1. Each of the second and third pixels PXL2 and PXL3 may be configured similarly to the first pixel PXL1.

Referring to FIG. 4, the first pixel PXL1 may include a light emitting unit EMU generating light of a luminance corresponding to a data signal, and the pixel circuit PXC for driving the light emitting unit EMU.

The light emitting unit EMU may include the first light emitting element LD1 connected between a first power line PL1 supplied with a voltage of first driving power VDD and a second power line PL2 supplied with a voltage of second driving power VSS. As an example, the light emitting unit EMU may include a (1-1)-th electrode EL1_1 connected to the first driving power VDD via the pixel circuit PXC and the first power line PL1, and the second electrode EL2 connected to the second driving power VSS via the second power line PL2. A potential difference between the first driving power VDD and the second driving power VSS may be set to be substantially equal to or higher than a threshold voltage of the first light emitting element LD1 during an emission period of the first pixel PXL1.

In an embodiment, the first light emitting element LD1 may be an organic light emitting diode including an organic light emitting layer. In another embodiment, the first light emitting element LD1 may be an inorganic light emitting element formed of an inorganic material. In still another embodiment, the first light emitting element LD1 may be a light emitting element configured of a combination of an inorganic material and an organic material. As another example, the first light emitting element LD1 may have a form in which inorganic light emitting elements are connected in parallel and/or series between the second driving power VSS and a fourth node N4.

The pixel circuit PXC of the first pixel PXL1 may be electrically connected to i-th first to third scan lines SL1_i to SL3_i and j-th data line DLj. The pixel circuit PXC may be electrically connected to an i-th emission control line ECLi.

The above-described pixel circuit PXC may include first to seventh transistors M1 to M7 and a storage capacitor Cst.

The first transistor M1 may be connected between a second node N2 and a third node N3. The first transistor M1 may generate a driving current and provide the driving current to the first light emitting element LD1. A gate electrode of the first transistor M1 may be connected to a first node N1. The first transistor M1 may control a current amount (driving current) flowing from the first driving power VDD to the second driving power VSS via the first light emitting element LD1 based on a voltage of the first node N1.

The second transistor M2 may be connected between the j-th data line DLj and the second node N2. A gate electrode of the second transistor M2 may be connected to an i-th first scan line SL1_i. The second transistor M2 may be turned on in case that a first scan signal is supplied to the i-th first scan line SL1_i to electrically connect the data line DLj and the second node N2.

The third transistor M3 may be connected between the first node N1 and the third node N3. A gate electrode of the third transistor M3 may be connected to the i-th first scan line SL1_i. The third transistor M3 may be turned on simultaneously with the second transistor M2.

The fourth transistor M4 may be connected between the first node N1 and initialization power Vint. A gate electrode of the fourth transistor M4 may be connected to an i-th second scan line SL2_i. The fourth transistor M4 may be turned on by a second scan signal supplied to the i-th second scan line SL2_i. In case that the fourth transistor M4 is turned on, a voltage of the initialization power Vint may be supplied to the first node N1 (for example, the gate electrode of the first transistor M1).

The fifth transistor M5 may be connected between the first driving power VDD and the second node N2. A gate electrode of the fifth transistor M5 may be connected to the i-th emission control line ECLi. The sixth transistor M6 may be connected between the third node N3 and the first light emitting element LD1. A gate electrode of the sixth transistor M6 may be connected to the i-th emission control line ECLi. The fifth transistor M5 and the sixth transistor M6 may be turned off in case that an emission control signal is supplied to the i-th emission control line ECLi, and may be turned on in other cases.

According to an embodiment, in case that the fifth and sixth transistors M5 and M6 are turned on, the current flowing in the first transistor M1 may be transmitted to the first light emitting element LD1, and the first light emitting element LD1 may emit light. An emission period of the first light emitting element LD1 may be determined in response to a turn-on period of the fifth and sixth transistors M5 and M6. The turn-on period of the fifth and sixth transistors M5 and M6 may correspond to an on-duty (emission period) of the emission control signal, and a turn-off period of the fifth and sixth transistors M5 and M6 may correspond to an off-duty (non-emission period) of the emission control signal.

The seventh transistor M7 may be connected to a first electrode of the first light emitting element LD1 (for example, the fourth node N4). A gate electrode of the seventh transistor M7 may be connected to an i-th third scan line SL3_i. The seventh transistor M7 may be turned on by a third scan signal supplied to the i-th third scan line SL3_i to supply the voltage of the initialization power Vint to the first electrode of the first light emitting element LD1.

The storage capacitor Cst may be connected between the first driving power VDD and the first node N1. The storage capacitor Cst may include a first storage electrode and a second storage electrode. The first storage electrode may be electrically connected to the first driving power VDD, and the second storage electrode may be electrically connected to the first node N1. The storage capacitor Cst may charge the data voltage corresponding to the data signal supplied to the first node N1 during a frame period. Accordingly, the storage capacitor Cst may store a voltage corresponding to a potential difference between a voltage of the gate electrode of the first transistor M1 and the first driving power VDD.

FIG. 4 illustrates an embodiment in which all of the first to seventh transistors M1 to M7 are P-type transistors, but embodiments of the disclosure are not limited thereto. For example, at least one of the first to seventh transistors M1 to M7 may be an N-type transistor.

A structure of the pixel circuit PXC may be variously changed and implemented. As an example, the pixel circuit PXC may include seven transistors and two capacitors. According to an embodiment, the pixel circuit PXC may include five transistors and two capacitors. However, embodiments of the disclosure are not limited thereto.

In the following embodiment, for convenience of description, a horizontal direction (or an X-axis direction) on a plane is indicated as a first direction DR1, a vertical direction (or a Y-axis direction) on the plane is indicated as a second direction DR2, and a vertical direction on a cross-section is indicated as a third direction DR3.

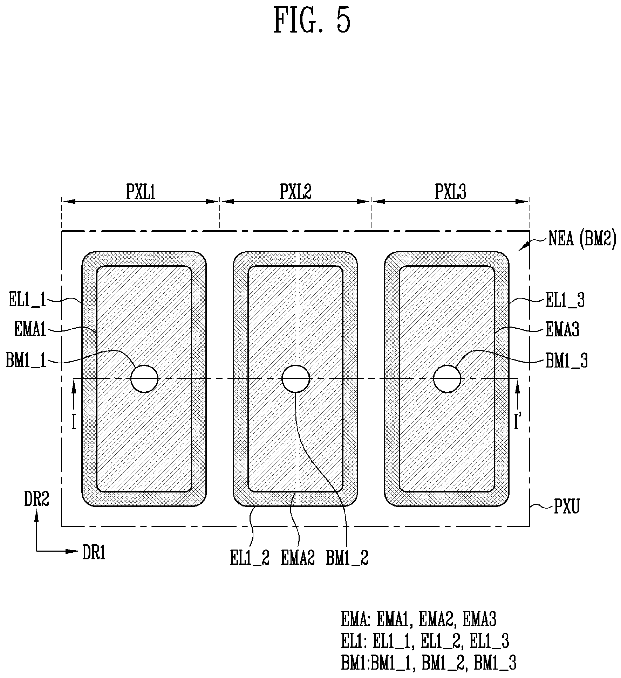

FIG. 5 is a schematic plan view illustrating an example of the pixel unit of FIG. 2.

Referring to FIGS. 2 and 5, the pixel unit PXU may be positioned in the display area DA and may include an emission area EMA and a non-emission area NEA.

The pixel unit PXU may include the first to third pixels PXL1 to PXL3. The first to third pixels PXL1 to PXL3 may be arranged according to various structures (for example, a stripe structure, PENTILE^{™} and the like), and are not limited to FIG. 5.

The first pixel PXL1 may include a first emission area EMA1 and a non-emission area NEA adjacent to the first emission area EMA1 (or surrounding at least one side of the first emission area EMA1). The second pixel PXL2 may include a second emission area EMA2 and a non-emission area NEA adjacent to the second emission area EMA2 (or surrounding at least one side of the second emission area EMA2). The third pixel PXL3 may include a third emission area EMA3 and a non-emission area NEA adjacent to the third emission area EMA3 (or surrounding at least one side of the third emission area EMA3). The first emission area EMA1, the second emission area EMA2, and the third emission area EMA3 may configure the emission area EMA of each of the pixels PXL.

Each of the first to third pixels PXL1 to PXL3 may include the light emitting element LD1 (see FIG. 4) emitting light and circuit elements for driving the light emitting element LD1.

The first emission area EMA1 may be an area where light is emitted from the light emitting element LD1 (see FIG. 6) driven by the circuit elements of the first pixel PXL1. The second emission area EMA2 may be an area where light is emitted from the light emitting element LD2 (see FIG. 6) driven by the circuit elements of the second pixel PXL2. The third emission area EMA3 may be an area where light is emitted from the light emitting element LD3 (see FIG. 6) driven by the circuit elements of the third pixel PXL3.

The first emission area EMA1 may be an area emitting the light of the first color (for example, red). The second emission area EMA2 may be an area emitting the light of the second color (for example, green). The third emission area EMA3 may be an area emitting the light of the third color (for example, blue). However, embodiments of the disclosure are not limited thereto. The first to third emission areas EMA1 to EMA3 may emit light of the same color.

The light emitting element LD1 positioned in the first pixel PXL1 may include a (1-1)-th electrode EL1_1, a first light emitting layer EML1 (see FIG. 6) positioned on the (1-1)-th electrode EL1_1, and the second electrode EL2 (see FIG. 6) positioned on the first light emitting layer EML1. The light emitting element LD2 positioned in the second pixel PXL2 may include a (1-2)-th electrode EL1_2, a second light emitting layer EML2 (see FIG. 6) positioned on the (1-2)-th electrode EL1_2, and the second electrode EL2 positioned on the second light emitting layer EML2. The light emitting element LD3 positioned in the third pixel PXL3 may include a (1-3)-th electrode EL1_3, a third light emitting layer EML3 (see FIG. 6) positioned on the (1-3)-th electrode EL1_3, and the second electrode EL2 positioned on the third light emitting layer EML3. The (1-1)-th electrode EL1_1, the (1-2)-th electrode EL1_2, and the (1-3)-th electrode EL1_3 may configure the first electrodes EL1 of the pixels PXL.

The pixel unit PXU may include first light blocking members BM1 and second light blocking members BM2. In an embodiment, the first light blocking members BM1 and the second light blocking members BM2 may be formed in the same process and may be disposed in the same layer. The first light blocking members BM1 and the second light blocking members BM2 may be disposed to be spaced apart from each other. For example, a (1-1)-th light blocking member BM1_1 and a (1-2)-th light blocking member BM1_2 may be disposed to be spaced apart from each other with the second light blocking member BM2 therebetween. The (1-2)-th light blocking member BM1_2 and a (1-3)-th light blocking member BM1_3 may be disposed to be spaced apart from each other with the second light blocking member BM2 therebetween.

The first light blocking members BM1 and the second light blocking members BM2 may include a light blocking material. According to an embodiment, the first light blocking members BM1 and the second light blocking members BM2 may include a light absorbing material. For example, the first light blocking members BM1 and the second light blocking members BM2 may include a colorant including one or more of carbon black and lactam black. However, embodiments of the disclosure are not limited thereto, and the light absorbing material may include various materials.

The first light blocking members BM1 may overlap each of the first to third emission areas EMA1 to EMA3 in a plan view. The first light blocking members BM1 may be disposed in central portions of the first to third emission areas EMA1 to EMA3, respectively. For example, a (1-1)-th light blocking member BM1_1 may overlap the first emission area EMA1 in a plan view. In particular, the (1-1)-th light blocking member BM1_1 may be disposed in a central portion of the first emission area EMA1. A (1-2)-th light blocking member BM1_2 may overlap the second emission area EMA2 in a plan view. In particular, the (1-2)-th light blocking member BM1_2 may be disposed in a central portion of the second emission area EMA2. A (1-3)-th light blocking member BM1_3 may overlap the third emission area EMA3 in a plan view. In particular, the (1-3)-th light blocking member BM1_3 may be disposed in a central portion of the third emission area EMA3.

The second light blocking member BM2 may be disposed in the non-emission area NEA between the first to third emission areas EMA1 to EMA3. For example, the second light blocking member BM2 may surround each of the first to third emission areas EMA1 to EMA3 in a plan view.

As described above, the first to third pixels PXL1 to PXL3 may form first light blocking members BM1 in each emission area to lower a reflectance, thereby improving image quality of the display device DD.

Although not shown in FIG. 5, the (1-1)-th electrode EL1_1, the (1-2)-th electrode EL1_2, and the (1-3)-th electrode EL1_3 of the first to third pixels PXL1 to PXL3 may be electrically connected to the circuit elements of the pixel circuit layer PCL (see FIG. 3) through a contact hole. Hereinafter, the disclosure is described based on a stack structure (or a cross-sectional structure) of the pixels PXL.

FIG. 6 is a schematic cross-sectional view taken along line I-I' of FIG. 5 according to an embodiment of the display panel.

Referring to FIG. 6, each of the first to third pixels PXL1 to PXL3 may include the substrate SUB, the pixel circuit layer PCL, the light emitting element layer LDL, the thin-film encapsulation layer TFE, the color filter layer CFL, and the overcoat layer OC.

The light emitting element layer LDL may include the light emitting elements LD and the pixel defining layer PDL. The light emitting elements may include the first electrodes EL1, the light emitting layers EML, and the second electrode EL2.

The first electrodes EL1 may be disposed on the pixel circuit layer PCL. The first electrodes EL1 may include an opaque conductive material having reflectance capable of reflecting light, but embodiments of the disclosure are not limited thereto.

The pixel defining layer PDL may be positioned on the first electrodes EL1.

The light emitting layers EML may be disposed in an area defined by the pixel defining layer PDL. The light emitting layers EML may be respectively positioned on the first electrodes EL1 exposed by the pixel defining layer PDL. The light emitting layers EML may include a light generation layer emitting light, an electron transport layer transporting an electron, a hole transporting layer transporting a hole, and the like, but embodiments of the disclosure are not limited thereto.

The second electrode EL2 may be positioned on the light emitting layers EML and may cover the light emitting layers EML. The second electrode EL2 may be commonly provided to the first to third pixels PXL1 to PXL3.

In each of the first to third pixels PXL1 to PXL3 (see FIG. 2), a hole injected from the first electrodes EL1 and an electron injected from the second electrode EL2 may be transported into the light emitting layers EML. Through this, an exciton may be formed, and in case that the exciton transits from an excited state to a ground state, light may be generated and may be emitted in a form of visible light.

The light emitting elements LD may include the first light emitting element LD1 positioned in the first pixel PXL1, the second light emitting element LD2 positioned in the second pixel PXL2, and the third light emitting element LD3 positioned in the third pixel PXL3.

The first light emitting element LD1 may include the (1-1)-th electrode EL1_1, the first light emitting layer EML1, and the second electrode EL2. The second light emitting element LD2 may include the (1-2)-th electrode EL1_2, the second light emitting layer EML2, and the second electrode EL2. The third light emitting element LD3 may include the (1-3)-th electrode EL1_3, the third light emitting layer EML3, and the second electrode EL2.

Each of the (1-1)-th electrode EL1_1, the (1-2)-th electrode EL1_2, and the (1-3)-th electrode EL1_3 may be provided and/or formed on the pixel circuit layer PCL of a corresponding pixel. As an example, the (1-1)-th electrode EL1_1, the (1-2)-th electrode EL1_2, and the (1-3)-th electrode EL1_3 may be provided and/or formed on an insulating layer of the pixel circuit layer PCL having a flat surface through a photolithography process using a mask.

The (1-1)-th electrode EL1_1, the (1-2)-th electrode EL1_2, and the (1-3)-th electrode EL1_3 may be disposed to be spaced apart from each other. The (1-1)-th electrode EL1_1 may be an anode of the first light emitting element LD1, the (1-2)-th electrode EL1_2 may be an anode of the second light emitting element LD2, and the (1-3)-th electrode EL1_3 may be an anode of the third light emitting element LD3.

The (1-1)-th electrode EL1_1, the (1-2)-th electrode EL1_2, and the (1-3)-th electrode EL1_3 may include openings OP exposing an area of the pixel circuit layer PCL. The openings OP may be formed by changing the mask without a separate additional process. Each of the openings OP may completely overlap at least one of the first light blocking members BM1. For example, the (1-1)-th electrode EL1_1 may include a first opening OP1 overlapping the (1-1)-th light blocking member BM1_1. The (1-2)-th electrode EL1_2 may include a second opening OP2 overlapping the (1-2)-th light blocking member BM1_2. The (1-3)-th electrode EL1_3 may include a third opening OP3 overlapping the (1-3)-th light blocking member BM1_3.

The (1-1)-th electrode EL1_1 may be electrically connected to circuit elements of the pixel circuit layer PCL of the first pixel PXL1. The (1-1)-th electrode EL1_1 may be electrically connected to a second terminal of the sixth transistor M6 and a second terminal of the seventh transistor M7 of the first pixel PXL1 described with reference to FIG. 4.

The (1-2)-th electrode EL1_2 may be electrically connected to circuit elements of the pixel circuit layer PCL of the second pixel PXL2. The (1-3)-th electrode EL1_3 may be electrically connected to circuit elements of the pixel circuit layer PCL of the third pixel PXL3.

The (1-1)-th electrode EL1_1, the (1-2)-th electrode EL1_2, and the (1-3)-th electrode EL1_3 may be configured of a first conductive layer (for example, a source-drain layer) disposed on the pixel circuit layer PCL.

The (1-1)-th electrode EL1_1, the (1-2)-th electrode EL1_2, and the (1-3)-th electrode EL1_3 may be formed through the same process, may include the same material, and may be positioned in the same layer. The (1-1)-th electrode EL1_1, the (1-2)-th electrode EL1_2, and the (1-3)-th electrode EL1_3 may be formed of a material having a reflectance so that light emitted from the light emitting layers EML may proceed in the image display direction. As an example, the (1-1)-th electrode EL1_1, the (1-2)-th electrode EL1_2, and the (1-3)-th electrode EL1_3 may be formed of a conductive material (or substance). For example, the (1-1)-th electrode EL1_1, the (1-2)-th electrode EL1_2, and the (1-3)-th electrode EL1_3 may include a metal such as silver (Ag), magnesium (Mg), aluminum (Al), platinum (Pt), palladium (Pd), gold (Au), nickel (Ni), neodymium (Nd), iridium (Ir), chromium (Cr), titanium (Ti), and an alloy thereof. However, this is merely an example, and the (1-1)-th electrode EL1_1, the (1-2)-th electrode EL1_2, and the (1-3)-th electrode EL1_3 may be provided and/or formed as multiple layers in which at least two or more materials among metals, alloys, conductive oxides, and conductive polymers are stacked.

The pixel defining layer PDL may be positioned in the non-emission area NEA and may be a structure that defines the first to third emission areas EMA1 to EMA3. As an example, the pixel defining layer PDL may be a structure positioned on the pixel circuit layer PCL in the non-emission area NEA, defining the first emission area EMA1 of the first pixel PXL1, the second emission area EMA2 of the second pixel PXL2, and the third emission area EMA3 of the third pixel PXL3.

The pixel defining layer PDL may be opened to expose at least the first opening OP1 of the (1-1)-th electrode EL1_1 in the first emission area EMA1, the second opening OP2 of the (1-2)-th electrode EL1_2 in the second emission area EMA2, and the third opening OP3 of the (1-3)-th electrode EL1_3 in the third emission area EMA3.

The pixel defining layer PDL may be configured of an organic insulating layer including an organic material. The organic material may include, e.g., acryl resin, epoxy resin, phenolic resin, polyamide resin, polyimide resin, and the like. According to an embodiment, the pixel defining layer PDL may include a light absorbing material or may be coated with a light absorbent to serve to absorb incoming light from the outside. For example, the pixel defining layer PDL may include a carbon-based black pigment, but is not limited thereto.

The pixel defining layer PDL may protrude from a surface (or an upper surface) of the pixel circuit layer PCL in the third direction DR3.

The first light emitting layer EML1 may be disposed on the (1-1)-th electrode EL1_1 exposed by the pixel defining layer PDL. The first light emitting layer EML1 may fill the first opening OP1 of the (1-1)-th electrode EL1_1. Accordingly, a portion of the first light emitting layer EML1 filled in the first opening OP1 of the (1-1)-th electrode EL1_1 may contact the pixel circuit layer PCL.

The second light emitting layer EML2 may be disposed on the (1-2)-th electrode EL1_2 exposed by the pixel defining layer PDL. The second light emitting layer EML2 may fill the second opening OP2 of the (1-2)-th electrode EL1_2. Accordingly, a portion of the second light emitting layer EML2 filled in the second opening OP2 of the (1-2)-th electrode EL1_2 may contact the pixel circuit layer PCL.

The third light emitting layer EML3 may be disposed on the (1-3)-th electrode EL1_3 exposed by the pixel defining layer PDL. The third light emitting layer EML3 may fill the third opening OP3 of the (1-3)-th electrode EL1_3. Accordingly, a portion of the third light emitting layer EML3 filled in the third opening OP3 of the (1-3)-th electrode EL1_3 may contact the pixel circuit layer PCL.

The first to third light emitting layers EML1 to EML3 may configure the light emitting layers EML of the first to third pixels PXL1 to PXL3. The second electrode EL2 may be disposed on the first light emitting layer EML1 of the first pixel PXL1, the second light emitting layer EML2 of the second pixel PXL2, and the third light emitting layer EML3 of the third pixel PXL3.

The second electrode EL2 may be commonly provided to the first to third pixels PXL1 to PXL3. The second electrode EL2 may be provided in a plate shape over the entire display area DA, but embodiments of the disclosure are not limited thereto. The second electrode EL2 may be a second conductive layer disposed on the pixel circuit layer PCL, but is not limited thereto.

The second electrode EL2 may be a thin metal layer having a thickness sufficient to transmit light emitted from each of the first to third light emitting layers EML1 to EML3. The second electrode EL2 may be formed of a metal material or a transparent conductive material to have a relatively thin thickness. For example, the second electrode EL2 may be formed of various transparent conductive materials. For example, the second electrode EL2 may include at least one of various transparent conductive materials including indium tin oxide, indium zinc oxide, indium tin zinc oxide, aluminum zinc oxide, gallium zinc oxide, zinc tin oxide, or gallium tin oxide. The second electrode EL2 may be implemented as substantially transparent or translucent to satisfy a light transmittance (e.g., a predetermined or selectable light transmittance). Accordingly, light emitted from each of the first to third light emitting layers EML1 to EML3 positioned under the second electrode EL2 may pass through the second electrode EL2 and may be emitted in an upper direction of the thin-film encapsulation layer TFE.

The thin-film encapsulation layer TFE may be entirely provided and/or formed on the second electrode EL2.

The thin-film encapsulation layer TFE may include first to third encapsulation layers ENC1, ENC2, and ENC3 sequentially positioned on the second electrode EL2. The first encapsulation layer ENC1 may be positioned on the light emitting element layer LDL and may be positioned over at least a portion of the display area DA and the non-display area NDA. The second encapsulation layer ENC2 may be positioned on the first encapsulation layer ENC1 and may be positioned over at least a portion of the display area DA and the non-display area NDA. The third encapsulation layer ENC3 may be positioned on the second encapsulation layer ENC2 and may be positioned over at least a portion of the display area DA and the non-display area NDA. According to an embodiment, the third encapsulation layer ENC3 may be positioned throughout the display area DA and the non-display area NDA.

Each of the first and third encapsulation layers ENC1 and ENC3 may be formed of an inorganic layer including an inorganic material, and the second encapsulation layer ENC2 may be formed of an organic layer including an organic material. For example, the inorganic layer may include silicon nitride (SiNₓ) silicon oxide (SiOₓ), silicon oxynitride (SiOₓN_{y}), or the like. The organic layer may include an organic insulating material such as acrylic resin (polyacrylates resin), epoxy resin, phenolic resin, polyamides resin, polyimides resin, unsaturated polyesters resin, polyphenylenethers resin, polyphenylene sulfides resin, or benzocyclobutene (BCB).

The first light blocking members BM1, the second light blocking member BM2, and the color filters CF may be disposed on the thin-film encapsulation layer TFE.

The (1-1)-th light blocking member BM1_1 may overlap the first opening OP1 of the (1-1)-th electrode EL1_1 on a surface of the thin-film encapsulation layer TFE. The (1-2)-th light blocking member BM1_2 may overlap the second opening OP2 of the (1-2)-th electrode EL1_2 on a surface of the thin-film encapsulation layer TFE. The (1-3)-th light blocking member BM1_3 may overlap the third opening OP3 of the (1-3)-th electrode EL1_3 on a surface of the thin-film encapsulation layer TFE. The second light blocking member BM2 may overlap the pixel defining layer PDL on a surface of the thin-film encapsulation layer TFE.

For example, the first light blocking members BM1 and the second light blocking members BM2 may be a black matrix. According to an embodiment, the first light blocking members BM1 and the second light blocking members BM2 may include at least one light blocking material and/or reflective material so that the light emitted from the light emitting layers EML proceeds in the image display direction. Accordingly, light output efficiency of the pixel PXL may be further improved.

The color filters CF may include a first color filter CF1, a second color filter CF2, and a third color filter CF3. The first color filter CF1 may be disposed in the first pixel PXL1, the second color filter CF2 may be disposed in the second pixel PXL2, and the third color filter CF3 may be disposed in the third pixel PXL3.

The color filters CF may be a component that selectively transmit light of a color, and the display device DD may implement a full-color pixel structure and may protect other components.

The first color filter CF1 may be a color filter for forming the first pixel PXL1 and may overlap the first emission area EMA1. The first color filter CF1 may be disposed on a surface of the thin-film encapsulation layer TFE to correspond to the first light emitting layer EML1. The second color filter CF2 may be a color filter for forming the second pixel PXL2 and may overlap the second emission area EMA2. The second color filter CF2 may be disposed on a surface of the thin-film encapsulation layer TFE to correspond to the second light emitting layer EML2. The third color filter CF3 may be a color filter for forming the third pixel PXL3 and may overlap the third emission area EMA3. The third color filter CF3 may be disposed on a surface of the thin-film encapsulation layer TFE to correspond to the third light emitting layer EML3.

Colors of the first to third color filters CF1 to CF3 may match light emitting colors of the first to third emission areas EMA1 to EMA3, respectively. As an example, the first color filter CF1 may selectively transmit the light of the first color. The first color filter CF1 may be a red color filter and may include a red color filter material (for example, pigment, dye, or the like). The second color filter CF2 may selectively transmit the light of the second color. The second color filter CF2 may be a green color filter and may include a green color filter material (for example, pigment, dye, or the like). The third color filter CF3 may selectively transmit the light of the third color. The third color filter CF3 may be a blue color filter and may include a blue color filter material (for example, pigment, dye, or the like).

Each of the first to third color filters CF1 to CF3 may contact one of the first light blocking members BM1. The first color filter CF1 may contact the (1-1)-th light blocking member BM1_1. The second color filter CF2 may contact the (1-2)-th light blocking member BM1_2. The third color filter CF3 may contact the (1-3)-th light blocking member BM1_3.

FIG. 6 illustrates a case where neighboring color filters CF are disposed to be spaced apart from each other with the second light blocking member BM2 therebetween, but the neighboring color filters CF may at least partially overlap each other on the second light blocking member BM2.

The overcoat layer OC may be disposed on the first light blocking members BM1, the second light blocking member BM2, and the color filters CF. The overcoat layer OC may be provided over the first to third pixels PXL1 to PXL3. The overcoat layer OC may prevent an impurity such as moisture or air from permeating from the outside and damaging or contaminating the color filters CF. The overcoat layer OC may prevent a material of the color filters CF from spreading to another component.

The overcoat layer OC may include an organic material such as acrylic resin, epoxy resin, phenol resin, polyamide resin, polyimide resin, polyester resin, polyphenylenesulfide resin, or benzocyclobutene. However, embodiments of the disclosure are not limited thereto.

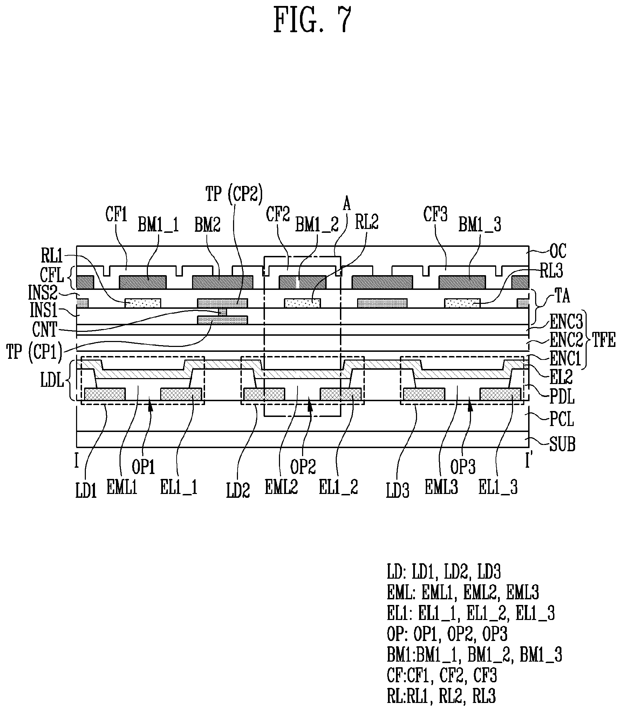

FIG. 7 is a schematic cross-sectional view taken along line I-I' of FIG. 5 according to an embodiment of the display panel. In order to avoid an overlapping description regarding the embodiment of FIG. 6, a point different from that of the above-described embodiment is described.

Referring to FIG. 7, a touch array TA may be further provided between the thin-film encapsulation layer TFE and the first light blocking members BM1.

The touch array TA may be disposed on the thin-film encapsulation layer TFE. The touch array TA may include a first insulating layer INS1, a first conductive pattern layer CP1, a second insulating layer INS2, and a second conductive pattern layer CP2.

The first conductive pattern layer CP1 and the second conductive pattern layer CP2 may be disposed in different layers to form touch electrodes TP. A connecting part CNT may connect first and second pattern layers CP1 and CP2. As an example, the first conductive pattern layer CP1 and the second conductive pattern layer CP2 may be patterned to form the touch electrodes TP. For example, a portion of the first conductive pattern layer CP1 may configure a first touch electrode, and a portion of each of the first conductive pattern layer CP1 and the second conductive pattern layer CP2 may configure a second touch electrode. However, embodiments of the disclosure are not limited thereto.

The first conductive pattern layer CP1 may be disposed on the thin-film encapsulation layer TFE. As described above, the thin-film encapsulation layer TFE may function as a base layer supporting the touch array TA. The first insulating layer INS1 may be disposed on the thin-film encapsulation layer TFE and the first conductive pattern layer CP1. The second conductive pattern layer CP2 may be disposed on the first insulating layer INS1. The first conductive pattern layer CP1 and the second conductive pattern layer CP2 may be spaced apart from each other with the first insulating layer INS1 therebetween.

The first conductive pattern layer CP1 and the second conductive pattern layer CP2 may include a metal layer of a single layer or multiple layers. The first conductive pattern layer CP1 and the second conductive pattern layer CP2 may include, e.g., at least one of various metal materials including gold (Au), silver (Ag), aluminum (Al), molybdenum (Mo), chromium (Cr), titanium (Ti), nickel (Ni), neodymium (Nd), copper (Cu), platinum (Pt), and the like, or an alloy thereof. According to an embodiment, the first conductive pattern layer CP1 may include, e.g., at least one of various transparent conductive materials including at least one of silver nanowire (AgNW), indium tin oxide (ITO), indium zinc oxide (IZO), indium gallium zinc oxide (IGZO), antimony zinc oxide (AZO), indium tin zinc oxide (ITZO), zinc oxide (ZnO), tin oxide (SnO₂), carbon nano tube, and graphene.

The first insulating layer INS1 may include one or more of an inorganic material and an organic material. The second insulating layer INS2 may include one or more of an inorganic material and an organic material. The inorganic material may include one or more of a group of silicon nitride (SiNₓ), silicon oxide (SiOₓ), silicon oxynitride (SiOₓN_{y}), and aluminum oxide (AlOₓ). The organic material may include, e.g., one or more of a group of acrylic resin, epoxy resin, phenol resin, polyamide resin, and polyimide resin. However, embodiments of the disclosure are not limited thereto.

The first light blocking members BM1, the second light blocking member BM2, and the color filters CF may be disposed on the touch array TA.

Reflective electrodes RL may be further provided between the thin-film encapsulation layer TFE and the first light blocking members BM1.

The reflective electrodes RL and at least some of the touch electrodes TP of the touch array TA may be disposed in a same layer and may include a same material. In embodiments, the reflective electrodes RL and the second conductive pattern layer CP2 may be disposed in a same layer and may include a same material. The reflective electrodes RL may be configured to reflect light and may prevent the light emitted from the light emitting layers EML from reaching the first light blocking members BM1. Light reflected by the reflective electrodes RL may be reflected again by the second electrode EL2 and/or the first electrodes EL1 and may be output to the color filters CF. Accordingly, the light output efficiency of the display device DD may be improved.

According to an embodiment, the reflective electrodes RL may be included in the first to third pixels PXL1 to PXL3. For example, the reflective electrodes RL may include a first reflective electrode RL1 included in the first pixel PXL1, a second reflective electrode RL2 included in the second pixel PXL2, and a third reflective electrode RL3 included in the third pixel PXL3.

The reflective electrodes RL may overlap the light emitting layers EML of the first to third pixels PXL1 to PXL3. For example, the first reflective electrode RL1 may overlap the first light emitting layer EML1. The second reflective electrode RL2 may overlap the second light emitting layer EML2. The third reflective electrode RL3 may overlap the third light emitting layer EML3.

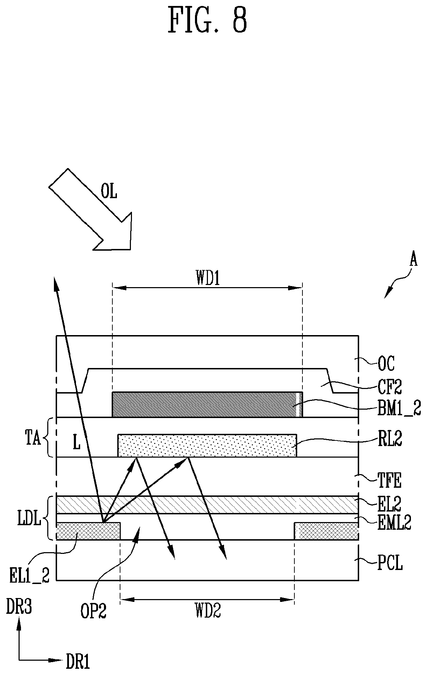

The reflective electrodes RL may overlap the openings OP of the (1-1)-th electrode EL1_1, the (1-2)-th electrode EL1_2, and the (1-3)-th electrode EL1_3, respectively. The reflective electrodes RL may overlap the first light blocking members BM1, respectively. For example, the first reflective electrode RL1 may overlap the first opening OP1 of the (1-1)-th electrode EL1_1. The first reflective electrode RL1 may also overlap the (1-1)-th light blocking member BM1_1. The second reflective electrode RL2 may overlap the second opening OP2 of the (1-2)-th electrode EL1_2. The second reflective electrode RL2 may also overlap the (1-2)-th light blocking member BM1_2. The third reflective electrode RL3 may overlap the third opening OP3 of the (1-3)-th electrode EL1_3. The third reflective electrode RL3 may also overlap the (1-3)-th light blocking member BM1_3. A width of each of the first to third openings OP1 to OP3 is described below with reference to FIGS. 8 to 10.

The reflective electrodes RL may face the first light blocking members BM1 in the third direction DR3 and may face the light emitting layers EML in a direction opposite to the third direction DR3.

As described above, by forming the reflective electrodes RL to overlap a lower portion of the first light blocking members BM1 of each of the first to third pixels PXL1 to PXL3, the light output efficiency of the display device DD may be improved through a light recycling effect.

FIGS. 8 to 10 are schematic enlarged views of portion A of FIG. 7 according to various embodiments of the display panel. Hereinafter, a configuration of the second pixel PXL2 is described with reference to FIGS. 8 to 10, but this may be substantially equally applied to each of the first and third pixels PXL1 and PXL3. An overlapping description thereof is omitted.

Referring to FIG. 8, the second pixel PXL2 may include the pixel circuit layer PCL, the (1-2)-th electrode EL1_2, the second light emitting layer EML2, the second electrode EL2, the thin-film encapsulation layer TFE, the second reflective electrode RL2, the (1-2)-th light blocking member BM1_2, the second color filter CF2, and the overcoat layer OC.

Light L may be emitted from an area where the second light emitting layer EML2 is disposed, and may be directed to the outside. In addition, a portion of the light L may be reflected by a lower surface of the second reflective electrode RL2. As described above, the light L may be directly emitted to the outside or recycled.

The (1-2)-th light blocking member BM1_2 may be disposed in the second emission area EMA2 (see FIG. 5) to prevent external light OL from entering the display device DD. For example, the (1-2)-th light blocking member BM1_2 may absorb at least a portion of the external light OL. Accordingly, a visibility decrease due to the external light OL and reflected light based on the external light OL may be prevented.

The second reflective electrode RL2 may be disposed under the (1-2)-th light blocking member BM1_2. The second opening OP2 of the (1-2)-th electrode EL1_2 may be disposed to overlap the (1-2)-th light blocking member BM1_2 under the second reflective electrode RL2. The second opening OP2 of the (1-2)-th electrode EL1_2 may be formed in an area that is not helpful in recycling of light L, thereby reducing current consumption. Accordingly, the power consumption of the display device DD may be reduced, and the lifespan of the display device DD may be improved.

The second opening OP2 of the (1-2)-th electrode EL1_2 may overlap the (1-2)-th light blocking member BM1_2, and the second opening OP2 and the (1-2)-th light blocking member BM1_2 may have substantially a same shape. For example, the (1-2)-th light blocking member BM1_2 and the second opening OP2 of the (1-2)-th electrode EL1_2 may have a circular shape or a quadrangular shape when viewed in the third direction DR3. The (1-2)-th light blocking member BM1_2 and the second opening OP2 of the (1-2)-th electrode EL1_2 may have a same shape and a same size. However, embodiments of the disclosure are not limited thereto, and the (1-2)-th light blocking member BM1_2 and the second opening OP2 of the (1-2)-th electrode EL1_2 may have different shapes.

The (1-2)-th light blocking member BM1_2 may have a first width WD1 in the first direction DR1, and the second opening OP2 of the (1-2)-th electrode EL1_2 may have a second width WD2 in the first direction DR1. The first width WD1 of the (1-2)-th light blocking member BM1_2 and the second width WD2 of the second opening OP2 of the (1-2)-th electrode EL1_2 may be substantially equal to each other. However, embodiments of the disclosure are not limited thereto.

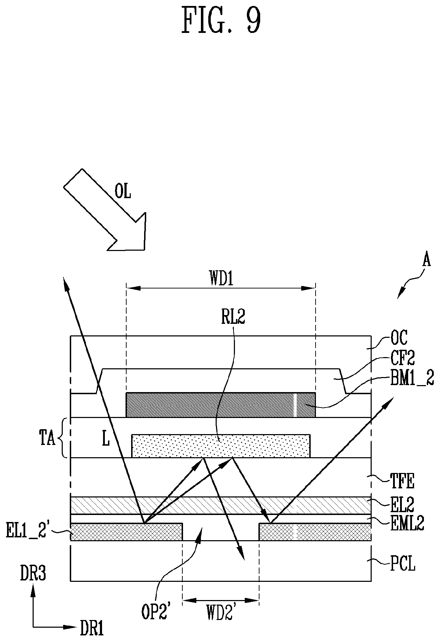

Referring to FIG. 9, a second opening OP2' of a (1-2)-th electrode EL1_2' may overlap the (1-2)-th light blocking member BM1_2. The (1-2)-th light blocking member BM1_2 may have the first width WD1 in the first direction DR1, and the second opening OP2' of the (1-2)-th electrode EL1_2' may have a second width WD2' in the direction DR1. The second width WD2' of the second opening OP2' of the (1-2)-th electrode EL1_2' may be less than the first width WD1 of the (1-2)-th light blocking member BM1_2. For example, in case that the second width WD2' is less than the first width WD1, recycling efficiency of the light L may be improved. For example, light reflected by the second reflective electrode RL2 may be reflected again by the (1-2)-th electrode EL1_2' by the relatively narrow second width WD2', and thus may reach the second color filter CF2. A shape and a size of the second opening OP2 of the (1-2)-th electrode EL1_2 may be variously designed to suit a product, thereby improving the light output efficiency.

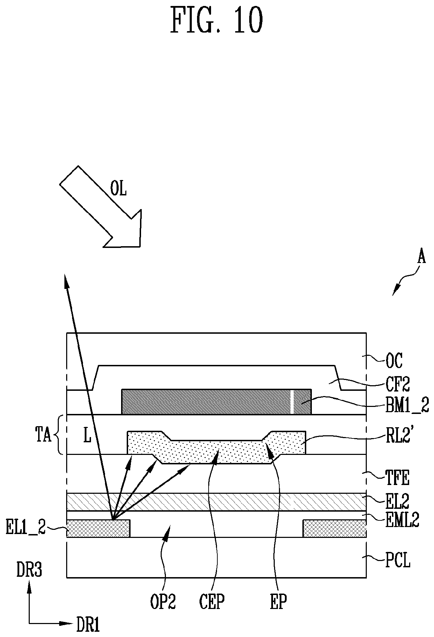

Referring to FIG. 10, a second reflective electrode RL2' may have a concave shape. The second reflective electrode RL2' may extend parallel to a surface formed by the first direction DR1 and the second direction DR2, and may have a shape concave in the direction opposite to the third direction DR3. The second reflective electrode RL2' may have a shape concave in a direction facing the second opening OP2 of the (1-2)-th electrode EL1_2. Through this, the second reflective electrode RL2' may relatively spread light reflected by the second reflective electrode RL2' to increase an opportunity to reach the (1-2)-th electrode EL1_2, thereby further increasing recycling efficiency.

For example, an edge portion EP of the second reflective electrode RL2' may be inclined at a certain angle and may have a concave shape. When viewed in a cross-sectional view, the second reflective electrode RL2' may have a shape in which a height of a central portion CEP is relatively low and a height of the edge portion EP is relatively high. As another example, a thickness of the edge portion EP of the second reflective electrode RL2' may be thicker than a thickness of the central portion CEP. However, this is an example, and various methods may be used to form the concave shape of the second reflective electrode RL2'.

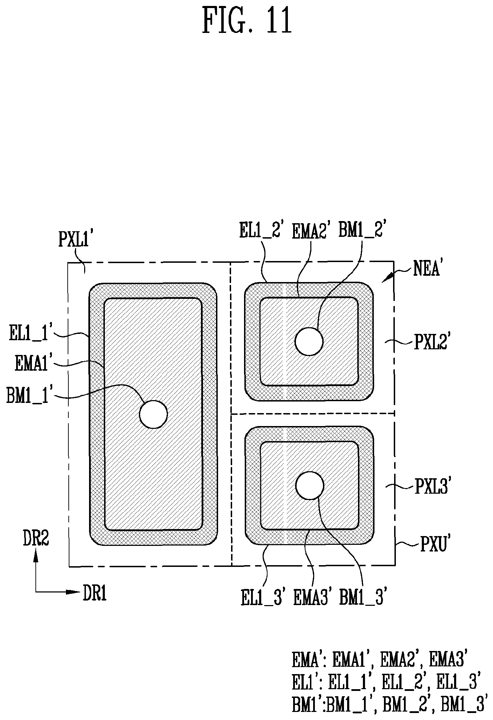

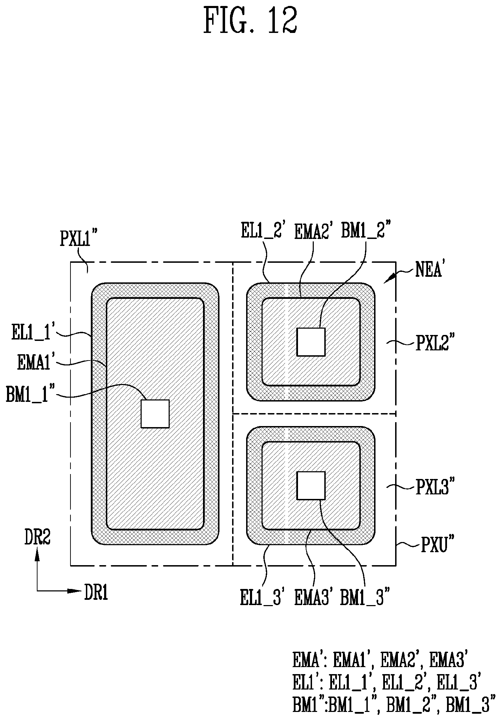

FIGS. 11 and 12 are schematic plan views illustrating other embodiments of the pixel unit of FIG. 2.

Referring to FIG. 11, a pixel unit PXU' may include a first pixel PXL1', a second pixel PXL2', and/or a third pixel PXL3'.

The first pixel PXL1' may include emission areas EMA' including a first emission area EMA1' and a non-emission area NEA' around the first emission area EMA1'. The second pixel PXL2' may include a second emission area EMA2' and a non-emission area NEA' around the second emission area EMA2'. The third pixel PXL3' may include a third emission area EMA3' and a non-emission area NEA' around the third emission area EMA3'. Electrodes EL1', EL1_1', EL1_2', EL1_3' may have various shapes, e.g., as shown in FIG. 11.

A light blocking member BM1' may include multiple light blocking members. A (1-1)-th light blocking member BM1_1' may be disposed in the first emission area EMA1'. A (1-2)-th light blocking member BM1_2' may be disposed in the second emission area EMA2'. A (1-3)-th light blocking member BM1_3' may be disposed in the third emission area EMA3'. The (1-1)-th light blocking member BM1_1', the (1-2)-th light blocking member BM1_2', and the (1-3)-th light blocking member BM1_3' may have circular shapes in a plan view. However, embodiments of the disclosure are not limited thereto.

The second pixel PXL2' and the third pixel PXL3' may be arranged in the second direction DR2. The first pixel PXL1' may be disposed in a direction opposite to the first direction DR1 with respect to each of the second and third pixels PXL2' and PXL3'.

The first pixel PXL1' may have an area greater than that of each of the second and third pixels PXL2' and PXL3'. Accordingly, the first emission area EMA1' may have an area greater than that of the second emission area EMA2'. The first emission area EMA1' may have an area greater than that of the third emission area EMA3'. However, the embodiments are not limited thereto. For example, the second and third pixels PXL2' and PXL3' may have different areas, and the first pixel PXL1' may have an area less than that of the second pixel PXL2' and/or the third pixel PXL3'.

An arrangement and/or an area of the first to third pixels PXL1' to PXL3' shown in FIGS. 5 and 11 are/is a description of an example, but embodiments of the disclosure are not limited thereto.

Referring to FIG. 12, a pixel unit PXU" may include a first pixel PXL1" including a (1-1)-th light blocking member BM1_1" disposed in the first emission area EMA1'. A second pixel PXL2" may include a (1-2)-th light blocking member BM1_2" disposed in the second emission area EMA2'. A third pixel PXL3" may include a (1-3)-th light blocking members BM1_3" disposed in the third emission area EMA3'. A light blocking member BM1" may refer to the (1-1)-th light blocking member BM1_1", (1-2)-th light blocking member BM1_2", and (1-3)-th light blocking member BM1_3".

The (1-1)-th light blocking member BM1_1", the (1-2)-th light blocking member BM1_2", and the (1-3)-th light blocking member BM1_3" may have polygonal shapes in a plan view. For example, shapes of the (1-1)-th light blocking member BM1_1", the (1-2)-th light blocking member BM1_2", and the (1-3)-th light blocking member BM1_3" may have quadrangular shapes as shown in FIG. 12. However, embodiments of the disclosure are not limited thereto.

A shape of the first light blocking members BM1 shown in FIGS. 11 and 12 is a description of an example, but embodiments of the disclosure are not limited thereto.

As discussed, embodiments provide a display device comprising: a pixel circuit layer disposed on a substrate; pixel electrodes overlapping emission areas on the pixel circuit layer; light emitting layers respectively disposed on the pixel electrodes; a common electrode disposed on the light emitting layers; an encapsulation layer covering the common electrode; and light blocking members disposed on the encapsulation layer, wherein the light blocking members include: first light blocking members overlapping a portion of the emission areas; and second light blocking members overlapping a non-emission area between the emission areas, and the pixel electrodes have openings respectively overlapping the first light blocking members.

Light may be emitted in regions where the pixel electrodes overlap the common electrode.

The size of the first light blocking members may be less than the size of the emission areas.

The first light blocking members may be provided as an island shape in the emission areas. For example, first light blocking members may be provided as a closed curve shape in central regions of the emission areas.

The size of the openings may be less than the size of the first light blocking members. The size of the openings may be the same as the size of the first light blocking members.

Each openings is completely overlapped by a first light blocking member.

A reflective layer may be provided between a first light blocking member and an opening (e.g. between each first light blocking member and its corresponding opening). The size of the reflective layers may be less than the size of the first light blocking members. The size of the reflective layers may be greater than the size of the openings.

The first light blocking members and the second light blocking members may be formed in the same process and may be disposed in the same layer. The first light blocking members and the second light blocking members may be disposed to be spaced apart from each other.

The first light blocking members and the second light blocking members may include a light blocking material. The first light blocking members and the second light blocking members may include a light absorbing material. For example, the first light blocking members and the second light blocking members may include a colorant including one or more of carbon black and lactam black.

The first light blocking members and the second light blocking members may be a black matrix.

The first light blocking members and the second light blocking members may include at least one light blocking material and/or reflective material so that the light emitted from the light emitting layers proceeds in the image display direction.

Although specific embodiments and application examples are described herein, other embodiments and modifications may be derived from the above description. Therefore, the disclosure is not limited to these embodiments, and extends to the scope of the claims set forth below, various obvious modifications, and equivalents.

According to embodiments of the disclosure, a display device with improved efficiency may be provided.

The above description is an example of technical features of the disclosure, and those skilled in the art to which the disclosure pertains will be able to make various modifications and variations. Thus, the embodiments of the disclosure described above may be implemented separately or in combination with each other.

Therefore, the embodiments disclosed in the disclosure are not intended to limit the disclosure, but to describe the disclosure, and the scope of the disclosure is not limited by these embodiments. The protection scope of the disclosure should be interpreted by the following claims.

## Claims

1. A display device (DD) comprising:
a pixel circuit layer (PCL) disposed on a substrate (SUB);
pixel electrodes (EL1_1, EL1_2, EL1_3) overlapping emission areas (EMA1, EMA2, EMA3) on the pixel circuit layer (PCL);
light emitting layers (EML1, EML2, EML3) respectively disposed on the pixel electrodes (EL1_1, EL1_2, EL1_3);
a common electrode (EL2) disposed on the light emitting layers (EML1, EML2, EML3);
an encapsulation layer (TFE) covering the common electrode (EL2); and
light blocking members (BM1, BM2) disposed on the encapsulation layer (TFE),
wherein
the light blocking members (BM1, BM2) include:
first light blocking members (BM1_1, BM1_2, BM1_3) overlapping a portion of the emission areas (EMA1, EMA2, EMA3); and
second light blocking members (BM2) overlapping a non-emission area (NEA) between the emission areas (EMA1, EMA2, EMA3),
the pixel electrodes (EL1_1, EL1_2, EL1_3) have openings (OP1, OP2, OP3) respectively overlapping the first light blocking members (BM1_1, BM1_2, BM1_3), and
**characterized in that** at least one of the openings (OP1, OP2, OP3) does not have an area that does not overlap a corresponding first light blocking member (BM1_1, BM1_2, BM1_3) among the first light blocking members (BM1_1, BM1_2, BM1_3).

2. The display device (DD) according to claim 1, wherein each of the openings (OP1, OP2, OP3) has a width less than a width of a first light blocking member (BM1_1, BM1_2, BM1_3) overlapping a corresponding opening (OP1, OP2, OP3) among the first light blocking members (BM1_1, BM1_2, BM1_3).

3. The display device (DD) according to claim 1, wherein each of the openings (OP1, OP2, OP3) and a first light blocking member (BM1_1, BM1_2, BM1_3) overlapping a corresponding opening (OP1, OP2, OP3) among the first light blocking members (BM1_1, BM1_2, BM1_3) have a same width.

4. The display device (DD) according to any one of claims 1 to 3, wherein each of the openings (OP1, OP2, OP3) and a first light blocking member (BM1_1, BM1_2, BM1_3) overlapping a corresponding opening (OP1, OP2, OP3) among the first light blocking members (BM1_1, BM1_2, BM1_3) have a same shape.

5. The display device (DD) according to any one of claims 1 to 4, wherein the light emitting layers (EML1, EML2, EML3) respectively fill the openings (OP1, OP2, OP3) of the pixel electrodes (EL1_1, EL1_2, EL1_3), and
wherein portions of the light emitting layers (EML1, EML2, EML3) filled in the openings (OP1, OP2, OP3) of the pixel electrodes (EL1_1, EL1_2, EL1_3) contact the pixel circuit layer (PCL).

6. The display device (DD) according to any one of claims 1 to 5, further comprising:
reflective electrodes (RL) disposed between the first light blocking members (BM1_1, BM1_2, BM1_3) and the encapsulation layer (TFE).

7. The display device (DD) according to claim 6, wherein the reflective electrodes (RL) respectively overlap the openings (OP1, OP2, OP3) of the pixel electrodes (EL1_1, EL1_2, EL1_3).

8. The display device (DD) according to claim 6 or 7, further comprising:
a touch array (TA) disposed between the first light blocking members (BM1_1, BM1_2, BM1_3) and the encapsulation layer (TFE),
wherein the reflective electrodes (RL) and touch electrodes (TP) of the touch array (TA) include a same material.

9. The display device (DD) according to any one of claims 6 to 8, wherein the reflective electrodes (RL) include a metal material.

10. The display device (DD) according to any one of claims 6 to 9, wherein each of the reflective electrodes (RL) has a shape concave in a direction facing the pixel electrodes (EL1_1, EL1_2, EL1_3).

11. The display device (DD) according to any one of claims 1 to 10, wherein the first light blocking members (BM1_1, BM1_2, BM1_3) are spaced apart from each other with a corresponding one of the second light blocking members (BM2) disposed between adjacent ones of the first light blocking members (BM1_1, BM1_2, BM1_3).

12. The display device (DD) according to any one of claims 1 to 11, wherein the first light blocking members (BM1_1, BM1_2, BM1_3) and the second light blocking members (BM2) are disposed in a same layer.

13. The display device (DD) according to any one of claims 1 to 12, wherein the first light blocking members (BM1_1, BM1_2, BM1_3) are respectively disposed in central portions of the emission areas (EMA1, EMA2, EMA3).

14. The display device (DD) according to any one of claims 1 to 13, further comprising:
color filters (CF1, CF2, CF3) respectively overlapping the light emitting layers (EML1, EML2, EML3), wherein
the color filters (CF1, CF2, CF3) respectively overlap the emission areas (EMA1, EMA2, EMA3), and
colors of the color filters (CF1, CF2, CF3) respectively match light emitting colors of the emission areas (EMA1, EMA2, EMA3),
wherein each of the color filters (CF1, CF2, CF3) contacts a first light blocking member (BM1_1, BM1_2, BM1_3) overlapping a corresponding color filter among the first light blocking members (BM1_1, BM1_2, BM1_3).

## Patentansprüche

1. Anzeigevorrichtung (DD), umfassend:
eine Pixelschaltungsschicht (PCL), die auf einem Substrat (SUB) angeordnet ist;
Pixelelektroden (EL1_1, EL1_2, EL1_3), die Emissionsbereiche (EMA1, EMA2, EMA3) auf der Pixelschaltungsschicht (PCL) überlappen;
lichtemittierende Schichten (EML1, EML2, EML3), die jeweils auf den Pixelelektroden (EL1_1, EL1_2, EL1_3) angeordnet sind;
eine gemeinsame Elektrode (EL2), die auf den lichtemittierenden Schichten (EML1, EML2, EML3) angeordnet ist;
eine Verkapselungsschicht (TFE), welche die gemeinsame Elektrode (EL2) bedeckt; und
lichtblockierende Elemente (BM1, BM2), die auf der Verkapselungsschicht (TFE) angeordnet sind, wobei
die lichtblockierenden Elemente (BM1, BM2) Folgendes beinhalten:
erste lichtblockierende Elemente (BM1_1, BM1_2, BM1_3), die einen Abschnitt der Emissionsbereiche (EMA1, EMA2, EMA3) überlappen; und
zweite lichtblockierende Elemente (BM2), die einen Nichtemissionsbereich (NEA) zwischen den Emissionsbereichen (EMA1, EMA2, EMA3) überlappen,
die Pixelelektroden (EL1_1, EL1_2, EL1_3) Öffnungen (OP1, OP2, OP3) aufweisen, die jeweils die ersten lichtblockierenden Elemente (BM1_1, BM1_2, BM1_3) überlappen, und
**dadurch gekennzeichnet, dass**
zumindest eine der Öffnungen (OP1, OP2, OP3) keinen Bereich aufweist, der ein entsprechendes erstes lichtblockierendes Element (BM1_1, BM1_2, BM1_3) unter den ersten lichtblockierenden Elementen (BM1_1, BM1_2, BM1_3) nicht überlappt.

2. Anzeigevorrichtung (DD) nach Anspruch 1, wobei jede der Öffnungen (OP1, OP2, OP3) eine Breite aufweist, die geringer als eine Breite eines ersten lichtblockierenden Elements (BM1_1, BM1_2, BM1_3), das eine entsprechende Öffnung (OP1, OP2, OP3) überlappt, unter den ersten lichtblockierenden Elementen (BM1_1, BM1_2, BM1_3) ist.

3. Anzeigevorrichtung (DD) nach Anspruch 1, wobei jede der Öffnungen (OP1, OP2, OP3) und ein erstes lichtblockierendes Element (BM1_1, BM1_2, BM1_3), das eine entsprechende Öffnung (OP1, OP2, OP3) überlappt, unter den ersten lichtblockierenden Elementen (BM1_1, BM1_2, BM1_3) eine gleiche Breite aufweisen.

4. Anzeigevorrichtung (DD) nach einem der Ansprüche 1 bis 3, wobei jede der Öffnungen (OP1, OP2, OP3) und ein erstes lichtblockierendes Element (BM1_1, BM1_2, BM1_3), das eine entsprechende Öffnung (OP1, OP2, OP3) überlappt, unter den ersten lichtblockierenden Elementen (BM1_1, BM1_2, BM1_3) eine gleiche Form aufweisen.

5. Anzeigevorrichtung (DD) nach einem der Ansprüche 1 bis 4, wobei die lichtemittierenden Schichten (EML1, EML2, EML3) jeweils die Öffnungen (OP1, OP2, OP3) der Pixelelektroden (EL1_1, EL1_2, EL1_3) füllen, und
wobei Abschnitte der lichtemittierenden Schichten (EML1, EML2, EML3), die in die Öffnungen (OP1, OP2, OP3) der Pixelelektroden (EL1_1, EL1_2, EL1_3) gefüllt sind, die Pixelschaltungsschicht (PCL) kontaktieren.

6. Anzeigevorrichtung (DD) nach einem der Ansprüche 1 bis 5, ferner umfassend:
reflektierende Elektroden (RL), die zwischen den ersten lichtblockierenden Elementen (BM1_1, BM1_2, BM1_3) und der Verkapselungsschicht (TFE) angeordnet sind.

7. Anzeigevorrichtung (DD) nach Anspruch 6, wobei die reflektierenden Elektroden (RL) jeweils die Öffnungen (OP1, OP2, OP3) der Pixelelektroden (EL1_1, EL1_2, EL1_3) überlappen.

8. Anzeigevorrichtung (DD) nach Anspruch 6 oder 7, ferner umfassend:
ein Berührungsarray (TA), das zwischen den ersten lichtblockierenden Elementen (BM1_1, BM1_2, BM1_3) und der Verkapselungsschicht (TFE) angeordnet ist,
wobei die reflektierenden Elektroden (RL) und Berührungselektroden (TP) des Berührungsarrays (TA) ein gleiches Material beinhalten.

9. Anzeigevorrichtung (DD) nach einem der Ansprüche 6 bis 8, wobei die reflektierenden Elektroden (RL) ein Metallmaterial beinhalten.

10. Anzeigevorrichtung (DD) nach einem der Ansprüche 6 bis 9, wobei jede der reflektierenden Elektroden (RL) eine Form aufweist, die konkav in einer Richtung ist, die den Pixelelektroden (EL1_1, EL1_2,EL1_3) zugewandt ist.

11. Anzeigevorrichtung (DD) nach einem der Ansprüche 1 bis 10, wobei die ersten lichtblockierenden Elemente (BM1_1, BM1_2, BM1_3) voneinander beabstandet sind, wobei ein entsprechendes der zweiten lichtblockierenden Elemente (BM2) zwischen benachbarten der ersten lichtblockierenden Elemente (BM1_1, BM1_2, BM1_3) angeordnet ist.

12. Anzeigevorrichtung (DD) nach einem der Ansprüche 1 bis 11, wobei die ersten lichtblockierenden Elemente (BM1_1, BM1_2, BM1_3) und die zweiten lichtblockierenden Elemente (BM2) in einer gleichen Schicht angeordnet sind.

13. Anzeigevorrichtung (DD) nach einem der Ansprüche 1 bis 12, wobei die ersten lichtblockierenden Elemente (BM1_1, BM1_2, BM1_3) jeweils in zentralen Abschnitten der Emissionsbereiche (EMA1, EMA2, EMA3) angeordnet sind.

14. Anzeigevorrichtung (DD) nach einem der Ansprüche 1 bis 13, ferner umfassend:
Farbfilter (CF1, CF2, CF3), welche die lichtemittierenden Schichten (EML1, EML2, EML3) jeweils überlappen, wobei
die Farbfilter (CF1, CF2, CF3) jeweils die Emissionsbereiche (EMA1, EMA2, EMA3) überlappen, und
Farben der Farbfilter (CF1, CF2, CF3) jeweils mit lichtemittierenden Farben der Emissionsbereiche (EMA1, EMA2, EMA3) übereinstimmen,
wobei jeder der Farbfilter (CF1, CF2, CF3) ein erstes lichtblockierendes Element (BM1_1, BM1_2, BM1_3), das einen entsprechenden Farbfilter überlappt, unter den ersten lichtblockierenden Elementen (BM1_1, BM1_2, BM1_3) kontaktiert.

## Revendications

1. Dispositif d'affichage (DD), comprenant :
une couche de circuit de pixels (PCL) disposée sur un substrat (SUB) ;
des électrodes de pixel (EL1_1, EL1_2, EL1_3) chevauchant des zones d'émission (EMA1, EMA2, EMA3) sur la couche de circuit de pixel (PCL) ;
des couches d'émission de lumière (EML1, EML2, EML3) respectivement disposées sur les électrodes de pixel (EL1_1, EL1_2, EL1_3) ;
une électrode commune (EL2) disposée sur les couches d'émission de lumière (EML1, EML2, EML3) ;
une couche d'encapsulation (TFE) recouvrant l'électrode commune (EL2) ; et
des éléments de blocage de lumière (BM1, BM2) disposés sur la couche d'encapsulation (TFE),
dans lequel
les éléments de blocage de lumière (BM1, BM2) comprennent :
de premiers éléments de blocage de lumière (BM1_1, BM1_2, BM1_3) chevauchant une partie des zones d'émission (EMA1, EMA2, EMA3) ; et
de seconds éléments de blocage de la lumière (BM2) chevauchant une zone de non émission (NEA) entre les zones d'émission (EMA1, EMA2, EMA3),
les électrodes de pixel (EL1_1, EL1_2, EL1_3) présentent des ouvertures (OP1, OP2, OP3) chevauchant respectivement les premiers éléments de blocage de lumière (BM1_1, BM1_2, BM1_3), et
**caractérisé en ce que**
au moins une des ouvertures (OP1, OP2, OP3) ne présente aucune zone qui ne chevauche pas un premier élément de blocage de lumière correspondant (BM1_1, BM1_2, BM1_3) parmi les premiers éléments de blocage de lumière (BM1_1, BM1_2, BM1_3).

2. Dispositif d'affichage (DD) selon la revendication 1, dans lequel chacune des ouvertures (OP1, OP2, OP3) présente une largeur inférieure à une largeur d'un premier élément de blocage de lumière (BM1_1, BM1_2, BM1_3) chevauchant une ouverture correspondante (OP1, OP2, OP3) parmi les premiers éléments de blocage de lumière (BM1_1, BM1_2, BM1_3).

3. Dispositif d'affichage (DD) selon la revendication 1, dans lequel chacune des ouvertures (OP1, OP2, OP3) et d'un premier élément de blocage de lumière (BM1_1, BM1_2, BM1_3) chevauchant une ouverture correspondante (OP1, OP2, OP3) parmi les premiers éléments de blocage de lumière (BM1_1, BM1_2, BM1_3) présentent une même largeur.

4. Dispositif d'affichage (DD) selon l'une quelconque des revendications 1 à 3, dans lequel chacune des ouvertures (OP1, OP2, OP3) et d'un premier élément de blocage de lumière (BM1_1, BM1_2, BM1_3) chevauchant une ouverture correspondante (OP1, OP2, OP3) parmi les premiers éléments de blocage de lumière (BM1_1, BM1_2, BM1_3) présentent une même forme.

5. Dispositif d'affichage (DD) selon l'une quelconque des revendications 1 à 4, dans lequel les couches d'émission de lumière (EML1, EML2, EML3) remplissent respectivement les ouvertures (OP1, OP2, OP3) des électrodes de pixel (EL1_1, EL1_2, EL1_3), et
dans lequel des parties des couches d'émission de lumière (EML1, EML2, EML3) remplissant les ouvertures (OP1, OP2, OP3) des électrodes de pixel (EL1_1, EL1_2, EL1_3) entrent en contact avec la couche de circuit de pixel (PCL).

6. Dispositif d'affichage (DD) selon l'une quelconque des revendications 1 à 5, comprenant en outre :
des électrodes réfléchissantes (RL) disposées entre les premiers éléments de blocage de lumière (BM1_1, BM1_2, BM1_3) et la couche d'encapsulation (TFE).

7. Dispositif d'affichage (DD) selon la revendication 6, dans lequel les électrodes réfléchissantes (RL) chevauchent respectivement les ouvertures (OP1, OP2, OP3) des électrodes de pixel (EL1_1, EL1_2, EL1_3).

8. Dispositif d'affichage (DD) selon la revendication 6 ou 7, comprenant en outre :
un réseau tactile (TA) disposé entre les premiers éléments de blocage de lumière (BM1_1, BM1_2, BM1_3) et la couche d'encapsulation (TFE),
dans lequel les électrodes réfléchissantes (RL) et les électrodes tactiles (TP) du réseau tactile (TA) comprennent un même matériau.

9. Dispositif d'affichage (DD) selon l'une quelconque des revendications 6 à 8, dans lequel les électrodes réfléchissantes (RL) comprennent un matériau métallique.

10. Dispositif d'affichage (DD) selon l'une quelconque des revendications 6 à 9, dans lequel chacune des électrodes réfléchissantes (RL) présente une forme concave dans une direction faisant face aux électrodes de pixel (EL1_1, EL1_2, EL1_3).

11. Dispositif d'affichage (DD) selon l'une quelconque des revendications 1 à 10, dans lequel les premiers éléments de blocage de lumière (BM1_1, BM1_2, BM1_3) sont espacés les uns des autres avec un élément correspondant parmi les seconds éléments de blocage de lumière (BM2) disposés entre des éléments adjacents parmi les premiers éléments de blocage de lumière (BM1_1, BM1_2, BM1_3).

12. Dispositif d'affichage (DD) selon l'une quelconque des revendications 1 à 11, dans lequel les premiers éléments de blocage de lumière (BM1_1, BM1_2, BM1_3) et les seconds éléments de blocage de lumière (BM2) sont disposés dans une même couche.

13. Dispositif d'affichage (DD) selon l'une quelconque des revendications 1 à 12, dans lequel les premiers éléments de blocage de lumière (BM1_1, BM1_2, BM1_3) sont respectivement disposés dans des parties centrales des zones d'émission (EMA1, EMA2, EMA3).

14. Dispositif d'affichage (DD) selon l'une quelconque des revendications 1 à 13, comprenant en outre :
des filtres de couleur (CF1, CF2, CF3) chevauchant respectivement les couches d'émission de lumière (EML1, EML2, EML3), dans lequel
les filtres de couleur (CF1, CF2, CF3) chevauchent respectivement les zones d'émission (EMA1, EMA2, EMA3), et
des couleurs des filtres de couleur (CF1, CF2, CF3) correspondent respectivement à des couleurs d'émission de lumière des zones d'émission (EMA1, EMA2, EMA3),
dans lequel chacun des filtres de couleur (CF1, CF2, CF3) entre en contact avec un premier élément de blocage de lumière (BM1_1, BM1_2, BM1_3) chevauchant un filtre de couleur correspondant parmi les premiers éléments de blocage de lumière (BM1_1, BM1_2, BM1_3).
